(19) Europäisches Patentamt
European Patent Office
Office européen des brevets

(11) **EP 2 096 621 A2**

## (12) EUROPEAN PATENT APPLICATION

(43) Date of publication:
**02.09.2009 Bulletin 2009/36**

(51) Int Cl.:
*G09G 3/20* (2006.01)

(21) Application number: **09152463.7**

(22) Date of filing: **10.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **29.02.2008 JP 2008049826**
**06.01.2009 JP 2009000765**

(71) Applicant: **Canon Kabushiki Kaisha**
**Tokyo 146-8501 (JP)**

(72) Inventors:
• **Shino, Kenji**
**Tokyo Tokyo 146-8501 (JP)**
• **Noine, Yasukazu**
**Tokyo Tokyo 146-8501 (JP)**

(74) Representative: **TBK-Patent**
**Bavariaring 4-6**
**80336 München (DE)**

(54) **Drive circuit of display panel and display apparatus**

(57)    A flexible printed circuit has ICs which drive display devices, connection wirings which connect the ICs and wirings on a display panel, and a resistor which is formed by the same process as the connection wirings. The ICs have a compensation circuit which compensates a voltage drop on the connection wirings. The compensation circuit applies an electric current flowing in the connection wirings or an electric current corresponding to this electric current to the resistor, so as to obtain a signal for compensating the voltage drop on the connection wirings. As a result, the voltage drop of the connection wirings on the flexile printed circuit can be accurately compensated.

Fig. 1

EP 2 096 621 A2

**Description**

BACKGROUND OF THE INVENTION

Field of the Invention

The present invention relates to a drive circuit of display panel and a display apparatus.

Description of the Related Art

Flat type display apparatuses such as electron beam display apparatuses, plasma display apparatuses, liquid crystal display apparatuses and organic EL display apparatus are known. This kind of display apparatus has a display panel (matrix panel) where a lot of display devices are arranged into a matrix pattern, and a drive circuit which drives the display panel. A flexible printed circuit in which an IC chip is packaged onto a flexible film is preferably used for drive circuits of display panel.

When the display panel is driven by flexible printed circuit, a voltage drop caused by resistance of wirings on the flexible printed circuit becomes a problem. The resistance of a connection wiring for connecting the IC chip and the display panel and an electric current applied to the connection wiring cause the voltage drop, and thus an effective voltage to be applied actually to the display devices becomes lower than an output voltage of IC.

In order to compensate the voltage drop caused by the resistance of the connection wiring on the flexible printed circuit, Japanese Patent Application Laid-Open No. 2004-233620 discloses the following constitution. An adjustment resistor having a resistance value corresponding to a resistance value of the connection wiring is provided. An electric current proportional to the electric current flowing in the connection wiring is applied to the adjustment resistor. A voltage which is generated by applying the electric current to the adjustment resistor is input into an operational amplifier, so that the voltage drop of the connection wiring is compensated.

SUMMARY OF THE INVENTION

The inventors of this invention study on accurately compensating the voltage drop caused by the resistance of wiring on a flexible printed circuit. They found that the inter-lot or inter-product variation in resistance value of wiring on a flexible printed circuit is not negligible in the course of the consideration. Thus, in a method for preparing a plurality of general-purpose resistor elements having the same resistance value and adding the general-purpose resistor element as an adjustment resistor to each flexible printed circuit, some flexible printed circuits whose voltage drop is not suitably compensated might be produced.

It is an object of the present invention to provide a constitution which accurately compensates a voltage drop in a connection wiring on a flexible printed circuit.

A first aspect of the present invention is a drive circuit which drives a display panel having display devices and wirings to be connected to the display devices, including: a flexible printed circuit which has ICs which drive the display devices, connection wirings which connect the ICs and the wirings, and a first resistor which is formed by the same process as the connection wirings, wherein the ICs have a compensation circuit which compensates a voltage drop in the connection wirings, and the compensation circuits apply electric currents flowing in the connection wirings or electric currents corresponding to the electric currents to the first resistors so as to obtain signals for compensating the voltage drop in the connection wirings.

A second aspect of the present invention is a display apparatus, including: the drive circuit; and a display panel which is driven by the drive circuit.

According to the present invention, the voltage drop of the connection wirings on the flexible printed circuit can be accurately compensated.

BRIEF DESCRIPTION OF THE DRAWINGS

FIG. 1 is a diagram illustrating a flexible printed circuit according to a first embodiment;
FIG. 2A is a plan view of an image display apparatus, and FIG. 2B is a cross-sectional view of the image display apparatus;
FIG. 3 is a block diagram illustrating a scan driving unit;
FIG. 4 is a diagram illustrating a circuit configuration of a conventional buffered switch;
FIG. 5 is a diagram illustrating signal waveforms at the time of driving scanning wirings;

FIG. 6 is a diagram illustrating a flexible printed circuit and a circuit substrate according to a second embodiment;
FIG. 7 is a diagram illustrating a circuit configuration of a drive circuit according to the first embodiment;
FIG. 8 is a diagram illustrating a circuit configuration of the drive circuit according to the second embodiment;
FIG. 9 is a diagram illustrating the flexible printed circuit according to a third embodiment;
FIG. 10 is a diagram illustrating a circuit configuration of the drive circuit according to the third embodiment
FIG. 11 is a diagram illustrating a conventional flexible printed circuit; and
FIG. 12A is a plan view illustrating a constitution which drives a liquid crystal backlight, and FIG 12B is a cross-sectional view illustrating the constitution which drives the liquid crystal backlight.

## DESCRIPTION OF THE EMBODIMENTS

Embodiments of the present invention are described below with reference to the drawings. In all the drawings of the embodiments, like or corresponding portions are denoted by like symbols.
The present invention can be applied preferably to an image display apparatus which has a display panel (matrix panel) where a lot of display devices are arranged into a matrix pattern. Examples of such a kind of image display apparatuses are electron beam display apparatuses, plasma display apparatuses, liquid crystal display apparatuses and organic EL display apparatuses. In an electron beam display apparatus, a cold cathode element such as an FE type electron-emitting device, an MIM type electron-emitting device or a surface conduction type emitting device is preferably used.

<First Embodiment>

(Constitution of Image Display Apparatus)

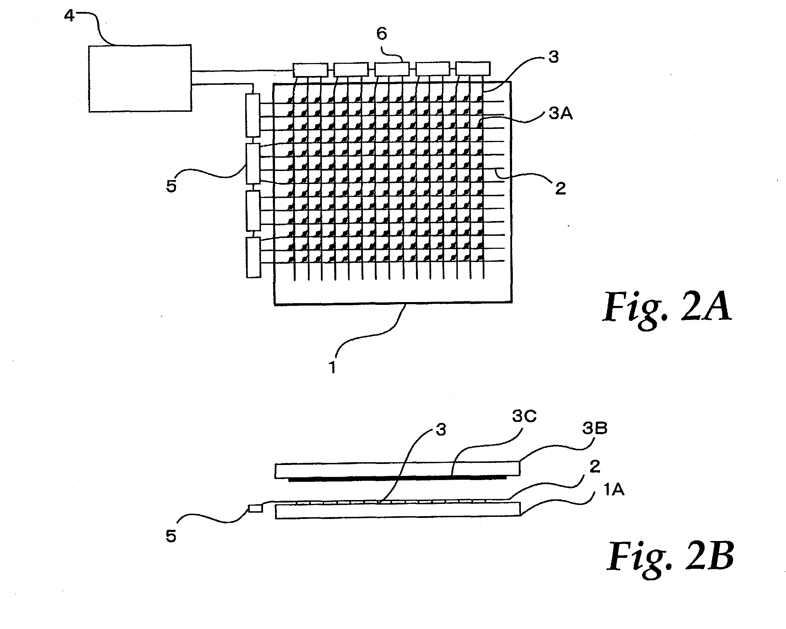

FIGS. 2A and 2B are diagrams illustrating a constitution of the image display apparatus, FIG. 2A is a plan view, and FIG. 2B is a cross-sectional view. The image display apparatus includes a matrix panel (display panel) 1, a control unit 4, a scan driving unit 5 and a modulation driving unit 6. The scan driving unit 5 and the modulation driving unit 6 are composed of ICs (integrated circuits). The matrix panel 1 has a rear plate 1A (device substrate) on which a plurality of electron-emitting devices 3A (also referred to as electron sources) is arranged, and a face plate 3B on which a phosphor 3C is arranged. Surface conduction type emitting devices are used as the electron-emitting devices 3A. The electron-emitting devices on the rear plate 1A are matrix-driven by scanning wirings 2 and modulation wirings 3.
The control unit 4 is a control circuit which outputs various control signals to the scan driving units 5 and the modulation driving unit 6. The control unit 4 is held on a circuit substrate separated from the matrix panel 1. The scan driving unit 5 is mounted onto a flexible printed circuit (FPC). Wirings formed on the flexible printed circuit connect between the scan driving unit 5 and the circuit substrate (control unit 4) and between the scan driving unit 5 and the matrix panel (scan wiring). The modulation driving unit 6 is also mounted onto the flexible printed circuit. Wirings on the flexible printed circuit connect between the modulation driving unit 6 and the circuit substrate (control unit 4) and between the modulation driving unit 6 and the matrix panel (modulation wiring).
The control unit 4 controls the scan driving unit 5 and the modulation driving unit 6, and a driving voltage of, for example, several dozens volts is applied between the scanning wirings 2 and the modulation wirings 3, so that electrons are emitted from electron-emitting devices 3A. A high voltage of several kV to several dozens kV is applied to the face plate 3B. The electrons emitted from the electron-emitting devices 3A are attracted to the face plate 3B, and collide against the phosphor 3C. As a result, light emission can be obtained. Brightness at this time is determined by an amount of the electrons colliding against the phosphor 3C for a predetermined period. Therefore, the brightness can be controlled by a value of the driving voltage or an applying period or both of them. As a result, gradation display is enabled.
In the first embodiment, the control unit 4 controls voltages of a scanning signal to be applied to the scanning wirings 2 and a modulation signal to be applied to the modulation wirings 3, so that various videos are displayed. The brightness obtained by light emission from the phosphor 3C is determined by the driving voltage (a potential difference between the scanning signal and the modulation signal) from the electron-emitting devices. Therefore, in order to obtain accurate luminance characteristics, stabilization of the driving voltage of the electron-emitting devices 3A, namely, prevention of waveform disturbance of the driving voltage (overshoot, undershoot, linking, or the like) becomes important.

(Driving Unit)

The scan driving unit 5 is a drive circuit which selects one or a plurality of scanning wirings 2. The scan driving unit 5 applies a selection potential to the scanning wirings 2 to be selected, and applies a non-selection potential to the other scanning wirings 2. The scanning wirings 2 to be selected are sequentially switched, so that scanning in a vertical direction is realized. The scan driving unit 5 is composed of integrated circuits (driving ICs). When a constitution such that one integrated circuit scans all the scanning wirings is adopted, a difference in path lengths from the integrated circuit to the respective scanning wirings becomes large. In order to solve this problem, a plurality (four) of integrated circuits (a plurality of flexible printed circuits) is used so as to compose the scan driving units 5 in the first embodiment.

The modulation driving unit 6 is a drive circuit which applies a modulation signal modulated based on an input image signal to the modulation wirings 3. The modulation signal is generated from an output of single or a plurality of constant voltage power sources. The modulation driving unit 6 is also composed of a plurality of integrated circuits (five flexible printed circuits in this embodiment).

(Modulation Signal)

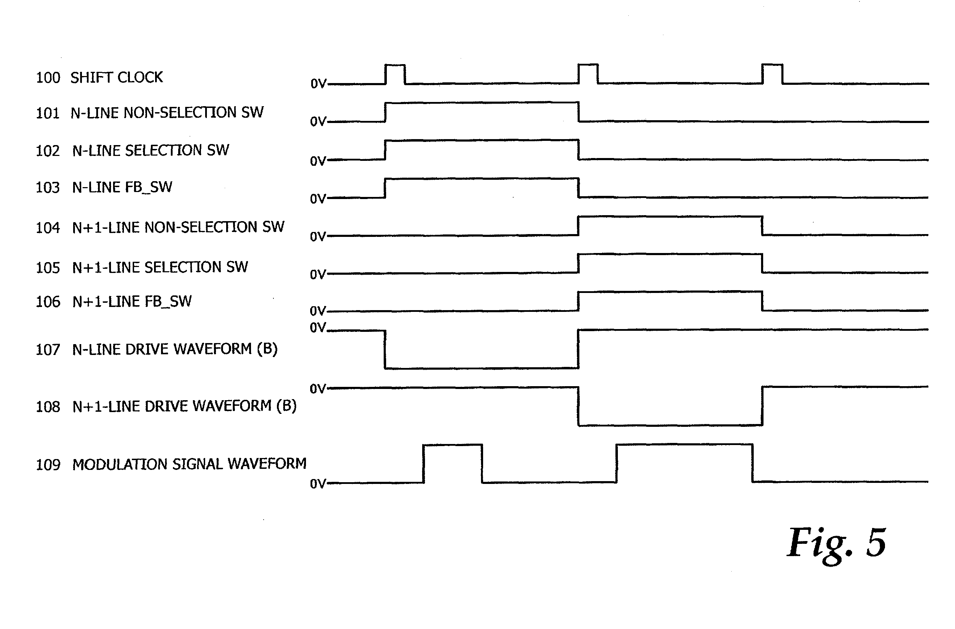

The modulation signal is described with reference to FIG. 5. Reference numeral 107 denotes a waveform of the scanning signal to be applied to the scanning wiring on line N, and 108 denotes a waveform of the scanning signal to be applied to the scanning wiring on line N+1. A selection potential of minus dozen V to several dozens V is applied to lines to be selected for a predetermined period (for example, one horizontal scanning period). Reference numeral 109 denotes a waveform of the modulation signal to be applied to a certain modulation wiring. The modulation driving unit 6 outputs a modulation signal for a period at which the selection potential is applied to the scanning wirings (low period). In the first embodiment, the modulation signal having a pulse width modulation waveform of plus several dozens V is used. Normally, in the image display apparatus using the surface conduction type emitting devices, as a pulse width is wider, an integrated value of luminance becomes larger, and the devices are brighter. In the example of FIG. 5, therefore, the luminance of the display device on the line N+1 is higher than that of the display device on the line N.

(Scan Driving Unit)

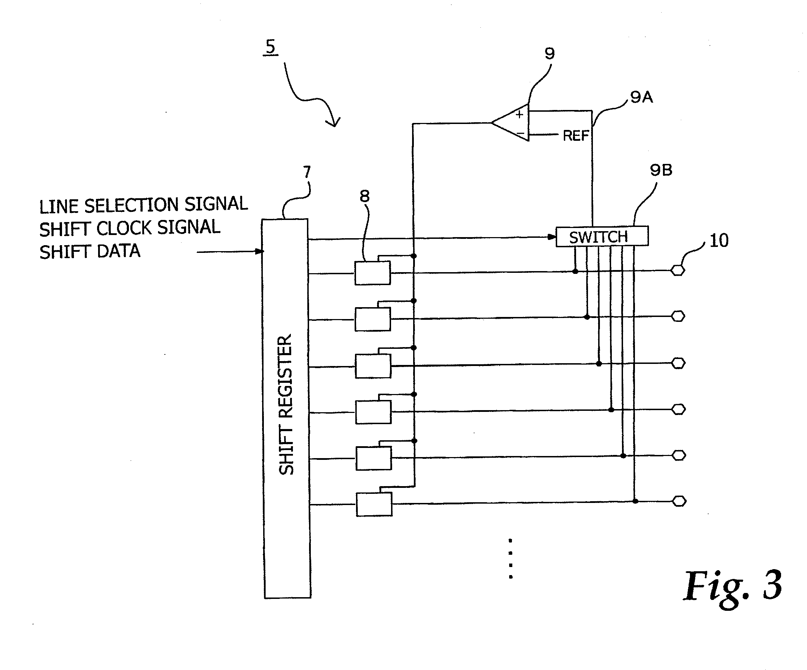

A basic constitution and an operation of the scan driving unit 5 (driving IC) having a feedback amplifier are described below. FIG. 3 is a block diagram of the scan driving unit 5. As shown in FIG. 3, the scan driving unit 5 has a shift register unit 7, buffered switches 8, a feedback switch 9B and a feedback amplifier 9.

The shift register unit 7 is a logic circuit which determines a line to be selected, and generates/outputs a control signal. The shift register unit 7 includes a shift register composed of a D flip-flop, not shown, and a logic device which performs logical operations on an output from the shift register, a shift clock and an output of shift data.

The buffered switch 8 is a circuit which converts shift data (control signal) output from the shift register unit 7 into a voltage/electric current level necessary for driving the scanning wirings so as to output the shift data.

The feedback switch 9B is a circuit which switches IC driving outputs (output terminals) 10 to be connected to an input 9A of the amplifier 9 based on a signal from the shift register unit 7. A potential of the IC driving output 10 corresponding to the selected line is fed back to the amplifier 9. A reference potential REF is connected to the other input of the amplifier 9. The amplifier 9 compares the fed back potential of the input 9A with the reference potential REF, and controls the buffered switches 8 based on a signal corresponding to their difference. As a result, a voltage drop in the IC caused by, for example, on-state resistance of a switch is compensated, so that the potential of the IC driving output 10 corresponding to the selected line is kept at the reference potential REF.

(Conventional Buffered Switch)

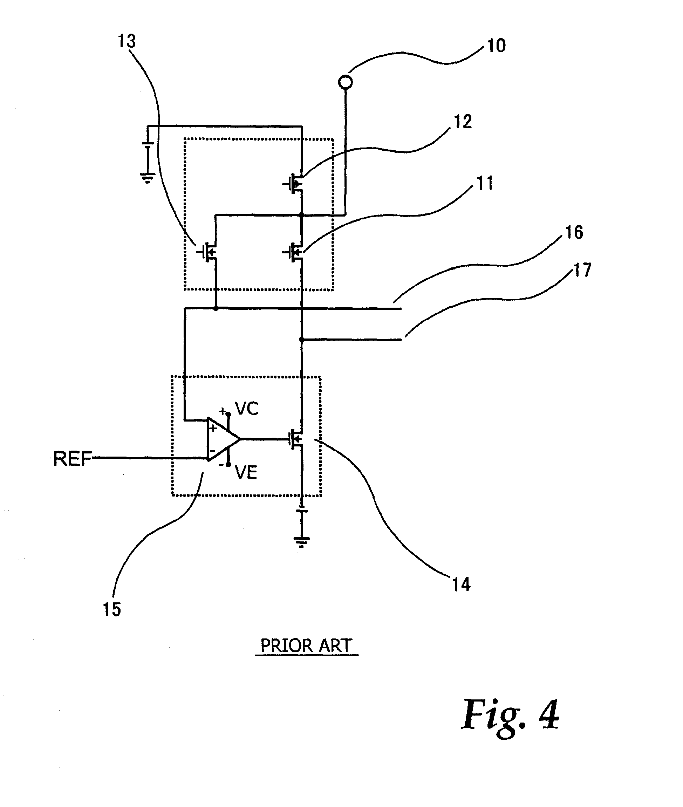

FIG. 4 illustrates a constitution of a conventional buffered switch 8. An Nch MOSFET 13 for FB (feedback) and an operational amplifier 15 in FIG. 4 correspond respectively to the feedback switch 9B and the amplifier 9 in FIG. 3. The Main Pch MOSFET 12 is an MOS switch which defines the IC driving output 10 to a non-selection potential. The Main Pch MOSFET 12 defines the IC driving output 10 to a non-selection potential for a period where an N-line non-selection SW signal 101 in FIG. 5 is low. A Main Nch MOSFET 11 is a switch which defines the IC driving output 10 to a selection potential, and is on while an N-line selection SW signal 102 in FIG. 5 is high. A source of the Main Nch MOSFET 11 is connected to a drain of an AMP_Nch MOSFET 14. The operational amplifier 15 controls the AMP_Nch MOSFET 14. A REF potential as the selection potential is connected to one input of the operational amplifier 15, and the IC driving output 10 is connected to the other input via the Nch MOSFET 13 for FB. An N-line FBSW signal 103 is input into a gate of the Nch MOSFET 13 for FB. The Nch MOSFET 13 for FB connects the potential of the IC driving output 10 to the operational amplifier 15 while the Main Nch MOSFET 11 is on. Therefore, the operational amplifier 15 compares the REF potential as the selection potential with the IC driving output 10, and controls the AMP_Nch MOSFET 14 so that the IC driving output 10 becomes the REF potential.

(Conventional Flexible Printed Circuit)

A flexible printed circuit to be used for the matrix panel is described below.

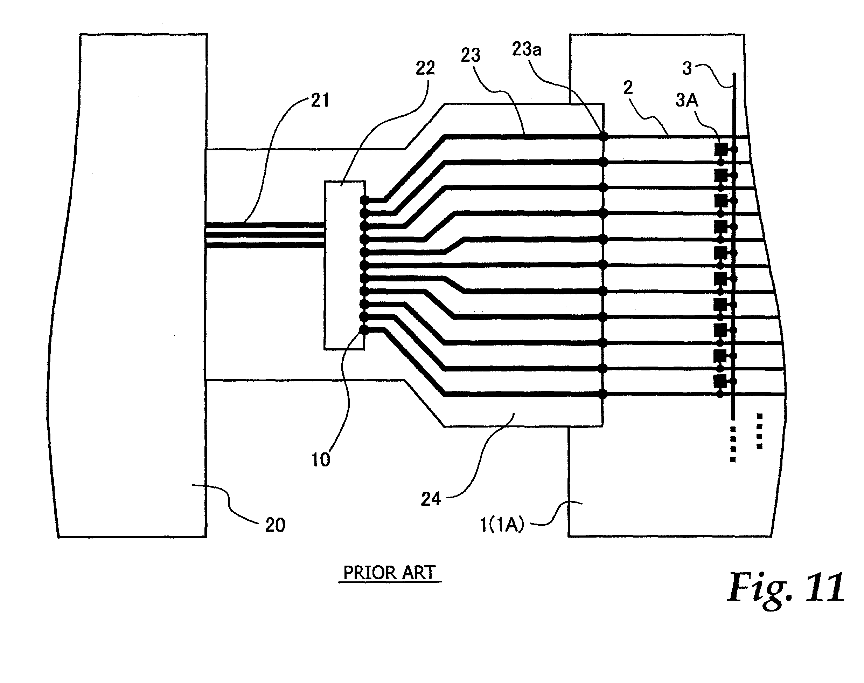

FIG. 11 illustrates a conventional TCP (tape carrier package) type flexible printed circuit. A driving IC 22 (corresponding to the scan driving unit 5) is packaged onto a polyimide film 24. Power source/control signal wirings 21 and driving output wirings 23 are formed on the polyimide film 24. The power source/control signal wirings 21 are wirings for supplying powers and control signals from the circuit substrate 20 onto which the control unit 4 is packaged to the IC 22. The driving output wirings 23 (connection wirings) are prepared correspondingly to output channels of the IC 22, and connect the IC driving outputs 10 of the IC 22 and the scanning wirings 2 on the matrix panel. End portions of the driving output wirings 23 on the scanning wiring side (matrix panel side) are hereinafter referred to as FPC outputs 23a.

The driving output wirings 23 are thin copper wirings with thickness of, for example, 35 $\mu$m. Further, since the driving output wirings 23 are necessary correspondingly to several dozens channels through several hundred channels in one IC, the wiring width becomes several dozens $\mu$m through several hundred $\mu$m. As a result, impedance of the driving output wirings 23 becomes several dozens m$\Omega$ through several hundred m$\Omega$. Therefore, when a driving current flowing in the driving output wirings 23 is high, a voltage drop in the driving output wirings 23 (a potential difference between the IC driving outputs 10 and the FPC outputs 23a) cannot be ignored.

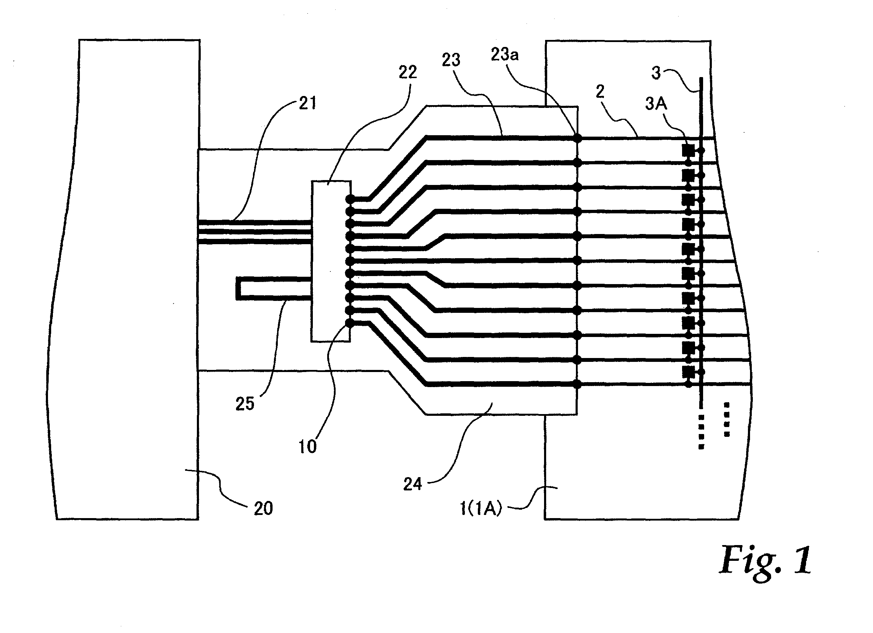

Therefore, conventionally a driving current is monitored and a voltage drop is estimated from a resistance value of the driving output wirings 23 measured in advance so that the voltage drop is corrected as shown in FIG. 1 in Japanese Patent Application Laid-Open No. 2004-233620.

However, such a conventional method has the following problem. That is to say, the driving output wirings 23 are formed by an etching process at a step of manufacturing the flexible printed circuit. In the case of the etching process, a thinning amount by means of the etching depends on etching time and temperature, wiring pattern and the like. Therefore, the impedance of the driving output wirings 23 changes due to a temperature condition or the like. Although the impedance of the wirings on the flexible printed circuit varies between lots and between individual substrates, the voltage drop is corrected on the condition where the impedance of the wirings in the conventional circuit has the same value. Therefore, in the conventional circuit, a correcting amount of the voltage drop may become too large or too small. In order to solve this problem, countermeasures such that accuracy of the etching process is heightened and the correcting amount is adjusted for each lot are necessary. Since such countermeasures, however, cause deterioration of a yield and an increase of the cost, these countermeasures are not preferable. Therefore, a constitution, which can easily realize the adjustment of the correcting amount according to the wiring impedance specific to a flexible printed circuits, is desired.

(Flexible Printed Circuit according to the First Embodiment)

In the first embodiment, a constitution of FIG. 1 is adopted in order to solve the conventional problem. This flexible printed circuit is a TCP type flexible printed circuit, and the driving IC 22 which drives the display devices is packaged onto the polyimide film 24. The power source/control signal wirings 21 and the plurality of driving output wirings 23 (connection wirings) areformedonthepolyimidefilm24. Thedriving IC 22 has the plural-channel IC driving outputs 10 (output terminals) (FIG. 1 shows an example of 11 channels), and the IC driving outputs 10 are connected one-to-one to the corresponding scanning wirings 2 by the driving output wirings 23. Further, a compensation wiring 25 is formed on the polyimide film 24. The compensation wiring 25 is used for detecting a voltage drop caused by the resistance of the driving output wirings 23 (potential difference between the IC driving outputs 10 and the FPC outputs 23a).

The compensation wiring 25 is formed so as to have a resistance value which is the same or proportional to the resistance value (impedance) of the driving output wirings 23. As discussed previously, the impedance of the driving output wirings 23 might vary due to processing conditions such as the etching time and temperature. Therefore, in the first embodiment, the compensation wiring 25 and the driving output wirings 23 are formed by the same process (etching process). As a result, a degree of a change in the impedance caused by the process conditions is equal for both wirings, and thus a resistance ratio between the compensation wiring 25 and the driving output wirings 23 can be constant. Therefore, an amount of the voltage drop in the driving output wirings 23 can be obtained based on a potential difference between both ends of the compensation wiring 25 at the time of applying the electric current flowing in the driving output wirings 23 (or an electric current proportional to that electric current) to the compensation wiring 25.

Normally, the same materials, thicknesses, widths and lengths are used for the compensation wiring 25 and the driving output wirings 23, so that the resistance values of both wirings may be equal. As shown in FIG. 1, the length of the driving output wirings 23 (length from the IC driving outputs 10 to the FPC outputs 23a) slightly varies on each channel. At this time, the length of the compensation wiring 25 may be matched with a representative length of the driving output wirings 23 (for example, average value or mode value). When the difference in the lengths of the driving output wirings 23 cannot be ignored, a plurality of compensation wirings 25 with different lengths (resistance values) may be formed on the flexible printed circuit. For example, the driving output wirings 23 are divided into several groups according to their lengths, and the compensation wirings 25 with different lengths are provided for the respective groups.

As shown in FIG. 1, the compensation wiring 25 is preferably arranged on a side opposite to the plurality of driving output wirings 23 across the driving IC 22 (namely, the side opposite to the matrix panel 1). Since the many driving output wirings 23 are present between the driving IC 22 and the matrix panel 1, it is difficult to make a space for arranging the compensation wiring 25. When the compensation wiring 25 is forcibly arranged, the driving output wirings 23 should be thinned, and thus loss due to the wiring resistance becomes large. When the compensation wiring 25 is arranged on the side opposite to the driving output wirings 23 as shown in FIG. 1, such a disadvantage can be repressed.

(Circuit Configuration and its Operation according to the First Embodiment)

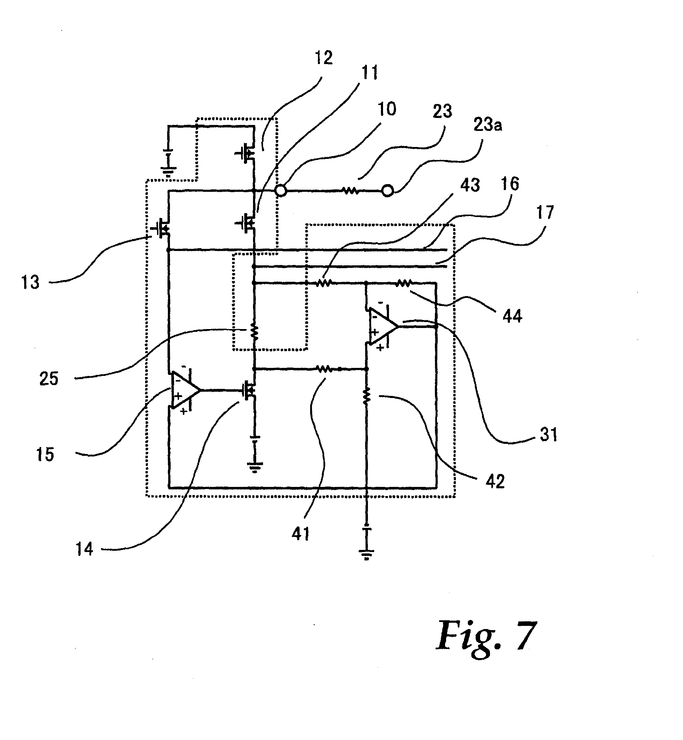

A configuration and an operation of a drive circuit according to the first embodiment are described with reference to FIG. 7. In FIG. 7, a portion surrounded by a broken line is an internal circuit of the driving IC 22. For easy description, FIG. 7 illustrates the circuit configuration for only one channel.

The Main Pch MOSFET 12 is a switch which controls the IC driving output 10 to a non-selection potential. A source of the Main Pch MOSFET 12 is connected to a power source of the non-selection potential, and its drain is connectedtothe ICdrivingoutput 10. The Main Nch MOSFET 11 is a switch which controls the IC driving output 10 to a selection potential. A drain of the Main Nch MOSFET 11 is connected to the IC driving output 10. The Nch MOSFET 13 for FB is a switch which feeds back the drain potential of the Main Nch MOSFET 11 to the operational amplifier 15. The AMP_Nch MOSFET 14 is a switch which amplifies an output from the operational amplifier 15. These four switches control the potential of the IC driving output 10. The operational amplifier 15 is a feedback control circuit which keeps the output potential of the IC driving output 10 at the REF potential (target potential).

The compensation wiring 25 is arranged between a source of the Main Nch MOSFET 11 and a drain of the AMP_Nch MOSFET 14. The driving output wirings 23 are arranged between the IC driving output 10 of the driving IC 22 and the FPC output 23a connected to the scanning wiring.

The operation of the drive circuit is described concretely with reference to FIG. 5. The operation at the time of non selection is firstly described. The N-line non-selection SW signal 101 is low for the non-selection period. While the N-line non-selection SW signal 101 is low, the Main Pch MOSFET 12 outputs the non-selection potential to the IC driving output 10.

The operation at the selection time is described below. For the selection period, the N-line selection SW signal 102 and the N-line FBSW signal 103 are high, and the Main Nch MOSFET 11 and the Nch MOSFET 13 for FB are turned on. For the selection period, the potential of the IC driving output 10 is maintained at the REF potential of the operational amplifier 15 by the feedback control using the operational amplifier 15, the AMP_Nch MOSFET 14 and the Nch MOSFET 13 for FB. As a result, the voltage caused by the on-state resistance of the switch in the IG is compensated. However, actually the driving output wirings 23 are present ahead of the IC driving output 10, and the voltage drop is caused also by the electric current flowing in the wirings outside the IC. Therefore, the electric current flowing in the driving output wiring 23 is applied to the compensation wiring 25. An operational circuit 31 composed of an operational amplifier calculates a potential difference between both ends of the compensation wiring 25, and outputs it to a plus input terminal of the operational amplifier 15 for feedback.

According to this configuration, when the electric current is applied to the driving output wiring 23 and the voltage drop occurs, the REF potential (target potential) of the operational amplifier 15 is adjusted, so that the potential of the IC driving output 10 is controlled. As a result, the voltage drop of the driving output wiring 23 is cancelled, and the potential of the FPC output 23a is kept constant regardless of the level of the electric current flowing in the driving output wiring 23. Since the resistance ratio between the compensation wiring 25 and the driving output wiring 23 is not influenced by the variation of the etching conditions, as discussed previously, the voltage drop of the driving output wiring 23 can be corrected accurately.

The potential of FPC output 23a is denoted by $V\alpha$, and the potential of the IC driving output 10 is denoted by $V\beta$. The resistance value of the driving output wiring 23 is denoted by R15, and the electric current flowing in the driving output wiring 23 is denoted by iR15. The resistance value of the compensation wiring 25 is denoted by R7, and the electric current flowing in the compensation wiring 25 is denoted by iR7.

The potential $V\alpha$ of the FPC output 23a rises with respect to the potential $V\beta$ by the voltage drop caused by the resistance of the driving output wiring 23 (R15 $\times$ iR15). Therefore, in order to set the potential $V\alpha$ to a desired output potential $V\gamma$, the following formula may hold:

$$V\beta \;=\; V\gamma - (R15 \;\times\; iR15).$$

"R15$\times$iR15" cannot be directly monitored. And so, the voltage drop caused by the resistance R7 of the compensation wiring 25 is monitored, and $V\beta$ is adjusted according to the voltage drop caused by the resistance R7, so that $V\beta = V\gamma - (R15 \times iR15)$ is realized.

In the configuration of FIG. 7, an output from the operational circuit 31 is input into the plus input (REF) of the operational amplifier 15 for feedback, and the operational amplifier 15 controls feedback so that the potential $V\beta$ reaches REF. Therefore, when the output from the operational circuit 31 (plus input of the operational amplifier 15) is set to $V\gamma$

- (R15 × iR15), the potential Vβ can be set to Vγ - R15 × iR15.

The potentials of both ends of the compensation wiring 25 are input into the minus input terminal and the plus input terminal of the operational circuit 31, respectively. The potential difference between both ends of the compensation wiring 25 is iR7 × R7. For this reason, when a gain of the operational circuit 31 is denoted by K and the power-source voltage is denoted by V3, the output from the operational circuit 31 is obtained as follows:

$$V3 - iR7 \times R7 \times K.$$

Since the electric currents flowing in the compensation wiring 25 and the driving output wiring 23 are equal to each other, iR7 is equal to iR15. Further, since the compensation wiring 25 and the driving output wirings 23 are made of the same material and formed by the same process, R15 = c × R7 (c is constant resistance ratio). Therefore, the output from the operational circuit 31 is as follows:

$$V3 - iR7 \times R7 \times K = V3 - iR15 \times R15 \times K \times 1/c$$

When the power-source voltage V3 is set to a desired output potential Vγ and the gain K is set to c, the output from the operational circuit 31 becomes Vγ - R15 × iR15. As a result, the potential Vα of the FPC output 23a can be Vα = Vγ = V3. In the constitution of FIG. 7, the operational amplifier 15, the MOSFET 14 and the operational circuit 31 compose a compensation circuit which compensates the voltage drop in the driving output wirings 23 (connection wirings). The compensation circuit applies the electric current iR15 (= iR7) flowing in the driving output wiring 23 to the compensation wiring 25 (first resistor), so as to obtain a signal for compensating the voltage drop in the driving output wirings 23 (output from the operational circuit 31).

The gain K of the operational circuit (operational amplifier) 31 can be adjusted by the resistance values of the resistors 41, 42, 43 and 44. In this embodiment, the width and the length of the compensation wiring 25 are the same as those of the driving output wirings 23, and their resistance values are equal to each other. For this reason, the resistance ratio c is 1. Therefore, the gain K is 1. K = 1 is realized by setting all the resistance values of the resistors 41, 42, 43 and 44 to 1 kΩ.

The resistance ratio c is not necessarily 1. For example, when the length of the compensation wiring 25 is set to a length which is half of the driving output wirings 23, the resistance ratio c is 2. In this case, the gain K of the operational circuit 31 may be set to 2. Concretely, the resistance value of the resistor 44 may be twice as large as that of the resistor 43. Since the resistors 41, 42, 43 and 44 are not resistors on the film 24, the variation in the resistance value is small, and the gain K can be determined accurately.

According to the compensation circuit of FIG. 7, even when the resistant value of the wirings formed on the flexible printed circuit varies among lots and among individual substrates, the potential of the output to be applied to the scanning wirings can be maintained at the constant value (V3).

In the first embodiment, although the TCP type flexible printed circuit is illustrated, the present invention can be applied to other types of flexible printed circuits such as COF type ones, producing the similar effect.

FIG. 7 illustrates the configuration for only one channel. The actual driving IC has the MOSFETs 11, 12 and 13 correspondingly to the respective channels. The operational amplifier 15, the MOSFET 14, the operational circuit 31, the resistors 41, 42, 43 and 44 and the compensation wiring 25 which relate to the compensation circuit are used commonly by a plurality of channels of the driving IC. A common wiring 16 connected to the compensation circuit is connected commonly to the sources of the MOSFETs 13 of all the channels. A common wiring 17 is connected commonly to the sources of the MOSFETs 11 of all the channels.

In the first embodiment, the electric current flowing in the driving output wirings 23 is applied directly to the compensation wiring 25 as the resistor for correcting the voltage drop. However, the electric current applied to the compensation wiring 25 needs only to correspond to the electric current flowing in the driving output wirings 23. For example, an electric current proportional to the electric current flowing in the driving output wirings 23 is generated by a current mirror circuit, and the electric current generated by the current mirror circuit may be applied to the compensation wiring 25. The mirror ratio can be set suitably.

<Second Embodiment>

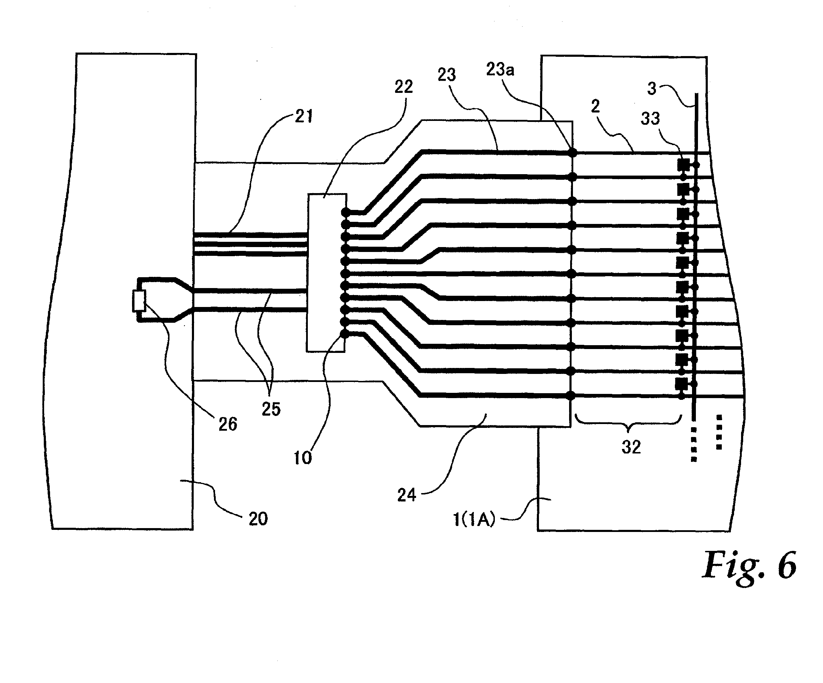

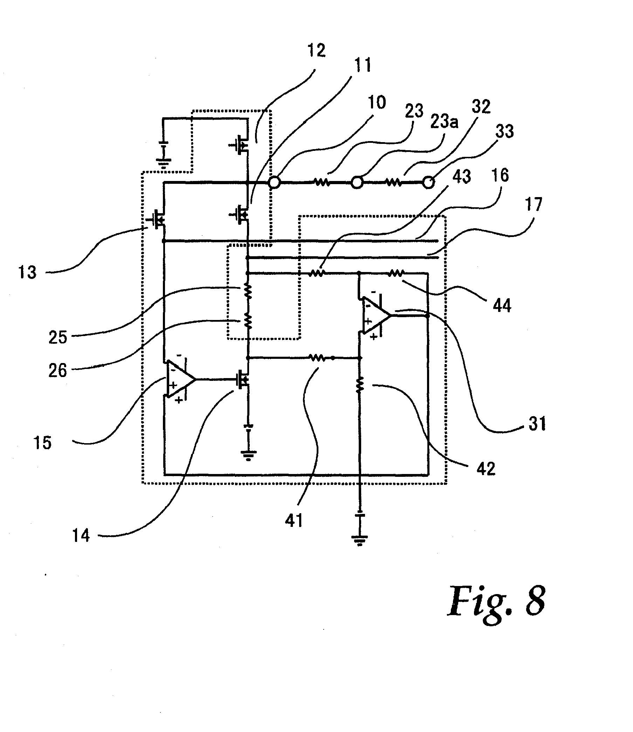

The drive circuit according to a second embodiment of the present invention is described below with reference to FIGS. 6 and 8. FIG. 6 is a diagram illustrating a constitution of the flexible printed circuit and the circuit substrate according to the second embodiment, and FIG. 8 is a diagram illustrating a circuit configuration of the drive circuit.

The drive circuit according to the first embodiment corrects the voltage drop caused by the on-state resistance inside the driving IC and the voltage drop caused by the wiring resistance on the flexible printed circuit. In the second embodiment, the drive circuit further corrects a voltage drop caused by the resistance of the end portions 32 of the scanning wirings 2 on the matrix panel 1 (portions between the FPC outputs 23a and the display devices 33 at the endmost portions). Since the other parts of the configuration are similar to the first embodiment, the description thereof is omitted, and the configuration specific to the second embodiment is mainly described.

The drive circuit according to the second embodiment has the compensation wiring 25 (first resistor) formed on the flexible printed circuit by the same process as that for the driving output wirings 23 similarly to the first embodiment. The compensation wiring 25 is a resistor for monitoring the voltage drop caused by the resistance of the driving output wirings 23. The drive circuit according to the second embodiment has a panel correcting resistor 26 (second resistor) for monitoring the voltage drop at the end portions 32 of the scanning wirings 2.

The panel correcting resistor 26 is set to the same resistance value as the resistance value of the end portions 32 of the scanning wirings 2. The resistance value of the scanning wirings 2 hardly varies due to the process unlike the wirings on the flexible printed circuit. Therefore, the panel correcting resistor 26 is composed of a discrete resistor element. It is difficult to arrange the discrete resistor element on the flexible printed circuit and to arrange also on the matrix panel 1 due to limitation of space. Therefore, in the second embodiment, the panel correcting resistor 26 is arranged on the printed substrate 20 (circuit substrate) to which the control unit 4 is packaged. The compensation wiring 25 is extended from the driving IC 22 to the side of the printed substrate 20 so that the compensation wiring 25 is connected to the panel correcting resistor 26 in series. Such a configuration ensures appropriate circuit arrangement and easy manufacturing.

The configuration and the operation of the drive circuit according to the second embodiment are described below with reference to FIG. 8. In FIG. 8, the portion surrounded by the broken line is a circuit inside the driving IC 22. For easy description, FIG. 8 illustrates the circuit configuration for only one channel.

The Main Pch MOSFET 12 is a switch which controls the IC driving output 10 to a non-selection potential. The source of the Main Pch MOSFET 12 is connected to the power source of the non-selection potential, and the drain is connected to the IC driving output 10. The Main Nch MOSFET 11 is a control switch which controls the IC driving output 10 to a selection potential. The drain of the Main Nch MOSFET 11 is connected to the IC driving output 10. The Nch MOSFET 13 for FB (feedback) is a switch which feeds back a drain potential of the Main Nch MOFET 11 to the operational amplifier 15. The AMP_Nch MOSFET 14 is a switch which amplifies an output from the operational amplifier 15. These four switches control the output potential of the IC driving output 10.

The compensation wiring 25 and the panel correcting resistor 26 are arranged between the source of the Main Nch MOSFET 11 and the drain of the AMP_Nch MOSFET 14 in series. The driving output wiring 23 is wirings between the IC driving output 10 of the driving IC 22 and the FPC output 23a to be connected to the scanning wiring. The end portion 32 of the scanning wiring 2 is a wiring between the FPC output 23a and the display device 33.

The operation of the drive circuit is described concretely with reference to FIG. 5. The operation at the time of non-selection is described first. The N-line non-selection SW signal 101 is low for the non-selection period. While the N-line non-selection SW signal 101 is low, the Main Pch MOSFET 12 outputs the non-selection potential to the IC driving output 10.

The operation at the time of selection is described below. The N-line selection SW signal 102 and the N-line FBSW signal 103 are high for a selection period, and the Main Nch MOSFET 11 and the Nch MOSFET 13 for FB are turned on. For the selection period, the potential of the IC driving output 10 is maintained at the REF potential (plus input potential) of the operational amplifier 15 by the feedback control using the operational amplifier 15, the AMP_Nch MOSFET 14 and the Nch MOSFET 13 for FB. As a result, the voltage drop caused by the on-state resistance of the switch inside the IC is compensated. However, actually the driving output wirings 23 are present ahead of the IC driving output 10, and the voltage drop is caused also by the electric current flowing in the wirings outside the IC. Further, since the wiring resistance is present between the FPC outputs 23a and the display devices, the voltage drop occurs. Therefore, the electric current flowing in the driving output wirings 23 is applied to the compensation wiring 25 and the panel correcting resistor 26. The operational circuit 31 composed of the operational amplifier calculates a potential difference between the compensation wiring 25 and both ends of the panel correcting resistor 26, and outputs it to the plus input terminal (REF potential) of the operational amplifier 15 for feedback.

According to this configuration, when the electric current is applied to the driving output wirings 23 and the scanning wirings 2 and the voltage drop occurs, the reference potential of the operational amplifier 15 is adjusted. The potentials of the IC driving outputs 10 are, thus, controlled. As a result, the voltage drop of the driving output wirings 23 and the voltage drop of the end portions 32 of the scanning wirings are cancelled, and the potentials of the scanning wirings in front of the electron-emitting device 33 in the matrix panel are kept constant regardless of the level of the electric current. Further, since the resistance ratio between the compensation wiring 25 and the driving output wirings 23 is not influenced by the variation of the etching conditions, as discussed previously, the voltage drop can be corrected accurately.

The resistance value of the panel correcting resistor 26 does not have to be the same as the resistance value of the end portions 32 of the scanning wirings. All that is required is that the resistance ratio between the panel correcting resistor 26 and the end portions 32 of the scanning wirings is equal to the resistance ratio c between the compensation wiring 25 and the driving output wirings 23. The gain K of the operational circuit 31 is set to an inverse number of c, so that an amount of the voltage drop at the driving output wirings 23 and the end portions 32 of the scanning wirings 2 can be obtained accurately.

<Third Embodiment>

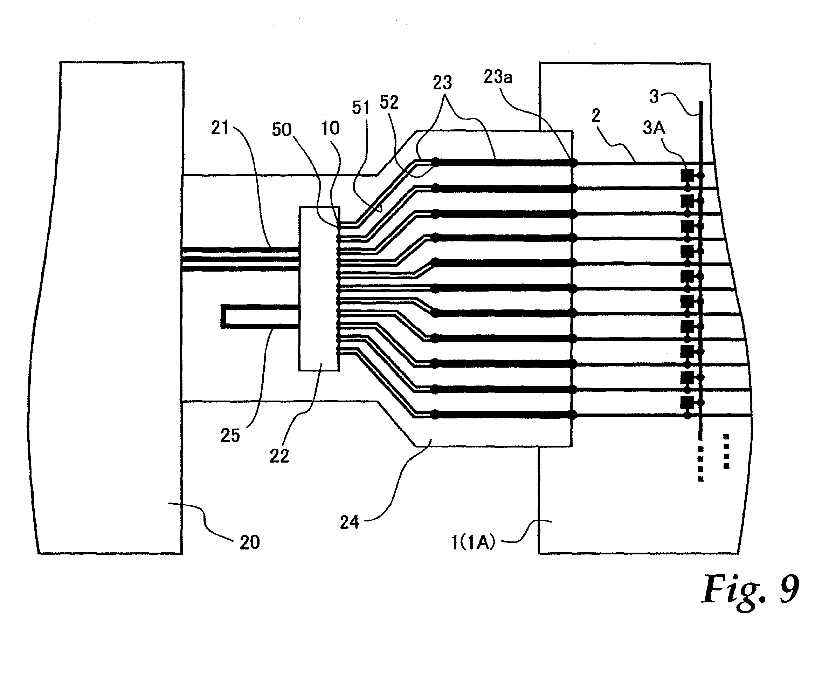

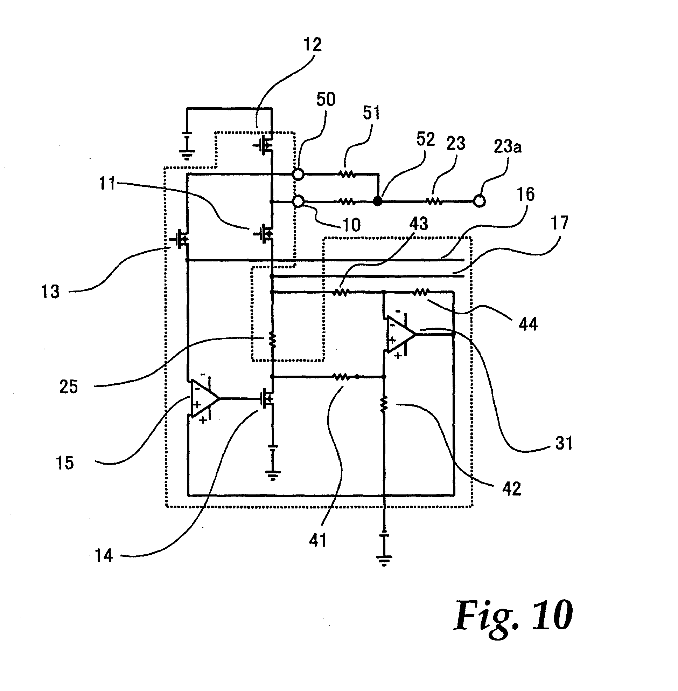

The drive circuit according to a third embodiment of the present invention is described with reference to FIGS. 9 and 10. FIG. 9 is a diagram illustrating a constitution of the flexible printed circuit according to the third embodiment, and FIG. 10 is a diagram illustrating a circuit configuration of the drive circuit.

In the first embodiment, the length of the compensation wiring 25 is matched with the representative length of the driving output wirings 23 (for example, average value). When the difference in the lengths of the driving output wirings 23 is slight, the matching does not particularly become a problem. However, the lengths of the driving output wirings 23 are greatly different or the accurate correction of the voltage drop is required, the difference in the lengths of the respective channels should be taken into consideration. In the third embodiment, therefore, the difference in the lengths of the channels is corrected by the feedback control. Since the other parts of the configuration are the same as those in the first embodiment, the description thereof is omitted, and the configuration specific to the third embodiment is mainly described.

As shown in FIG. 9, the driving IC 22 has output terminals (IC driving outputs 10) and FB (feedback) terminals 50 for respective channels. The driving output wirings 23 are connected to the output terminals 10, respectively, and the FB wiring 51 are connected to the FB terminals 50, respectively. The FB wirings 51 merge into the driving output wirings 23 in the respective channels. The merging points where the FB wirings 51 and the driving output wirings 23 meet are hereinafter referred to as potential detecting points 52. The FB wirings 51 detect potentials of the potential detecting points 52 on the driving output wirings 23, and feed back them to the driving IC 22. Positions of the potential detecting points 52 on the respective channels are determined so that the lengths between the potential detecting points 52 and the FPC outputs 23a (ends of the driving output wirings 23 on the display panel side) become equal for all the channels. The resistance value of the compensation wiring 25 is set so as to be the same as or proportional to the resistance value of the wirings between the potential detecting points 52 and the FPC outputs 23a.

The drive circuit according to the first embodiment (FIG. 7) has the configuration that the drain potential of the MOSFET 12 is fed back to the operational amplifier 15 in IC. On the contrary, the drive circuit according to the third embodiment (FIG. 10) feeds back the potential at the potential directing point 52 on the driving output wiring 23 to the operational amplifier 15 via the FB wirings 51. As a result, the voltage drop caused by the on-state resistance in the IC as well as the voltage drop caused by the wiring resistance from the output terminal 10 to the potential detecting point 52 is corrected. That is to say, the wiring length (wiring resistance) from the output terminal 10 to the potential detecting point 52 varies on each channel, but since the difference is absorbed by the feedback correction, the problem does not arise.

The voltage drop caused by the wiring resistance between the potential detecting points 52 and the FPC outputs 23a can be corrected by supplying an operational circuit output corresponding to the potential difference between both ends of the compensation wiring 25 to the plus input of the operational amplifier 15 as described in the first embodiment.

According to the configuration of the third embodiment, even when the wiring length on the flexible printed circuit varies on each channel, the voltage drop can be accurately corrected. When the panel correcting resistor in the second embodiment is combined with the drive circuit in the third embodiment, the correcting accuracy of the voltage drop can be improved.

<Fourth Embodiment>

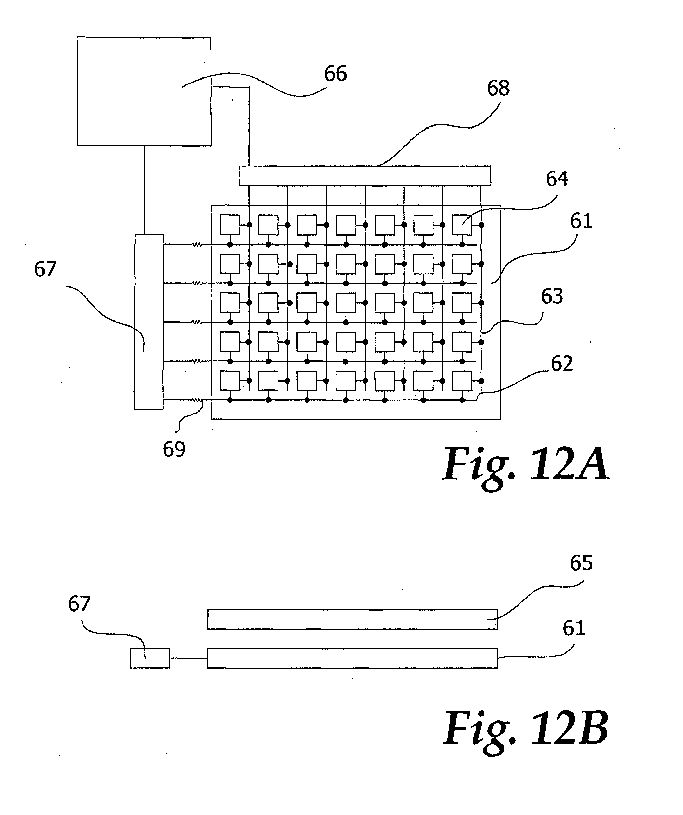

The first to third embodiments describe the method for driving the matrix panel of the image display apparatus. When the constitution that the scan driving units 5 are mounted onto the flexible printed circuit (FPC) is used and an LED backlight of a liquid crystal display apparatus is driven, luminance irregularity of the backlight is repressed and simultaneously the sequential driving at the low cost is enabled. FIGS. 12A and 12B are diagrams illustrating a constitution which drives an LED backlight of a liquid crystal display apparatus, FIG. 12A is a plan view, and FIG. 12B is a cross-sectional view.

The LED backlight of the liquid crystal display apparatus has an LED matrix 61, a control unit 66, a line driving unit 67 and a column driving unit 68. The line driving unit 67 and the column driving unit 68 are composed of IC (integrated circuit).

On the LED matrix 61, a plurality of LED blocks 64 (LEDs are connected in series) is arranged, and light is emitted from a back surface of a liquid crystal panel 65 according to the liquid crystal panel so that a desired image is displayed.

The LED blocks 64 on the LED matrix 61 are matrix-driven by line selection wirings 62 and column selection wirings 63. The line selection wirings 62 are connected to output terminals of the line driving unit 67 via resistors. The column selection wirings 63 are connected to output terminals of the column driving unit 68.

The control unit 66 controls the line driving unit 67 and the column driving unit 68, and applies a driving voltage of, for example, several dozens volts between the line selection wirings 62 and the column selection wirings 63 via resistors 69. As a result, light is emitted from the LED blocks 64. When light is emitted from the LED blocks according to a video of the liquid crystal panel 65, light is brightly emitted from bright portions on the screen, and light is slightly emitted from dark portions on the screen. As a result, the luminance control (local dimming) is enabled according to the video.

In the fourth embodiment, the control unit 66 controls the timing of switching into the column selection wirings 63, the selection time and timing of applying a voltage to the line selection wirings 62. As a result, the luminance is controlled in synchronization with the video.

The brightness obtained by the light emission from the LED blocks 64 is determined by an applied voltage to the LED blocks 64 (applied current to the LED blocks 64 controlled by the resistors 69). Therefore, in order to obtain accurate luminance characteristic without variation, the accurate control of the driving voltage (driving current) for the LED blocks 64 is important.

(Driving Unit)

The line driving unit 67 is a drive circuit which selects one or a plurality of line selection wirings 62. The minus driving unit 67 applies a selection potential of minus several dozens volt to the line selection wirings 62 to be selected, and applies a GND potential to the other line selection wirings 62. When the line selection wirings 62 to be selected are sequentially switched, the selection of the LED blocks 67 in a vertical direction is realized. The line driving unit 67 is composed of an integrated circuit.

The column driving unit 68 is a drive circuit which selects the column selection wirings 63 based on an input image signal, controls selection time and controls a light-emitting amount of the LED blocks 64.

In the LED matrix driving method, the line driving unit 67 and the column driving unit 68 are realized by using the circuit configurations of the scan driving unit 5 and the modulation driving unit 6 described in the first to third embodiments. As a result, influences of the flexible printed circuit and its variation can be corrected. As a result, since the voltage (electric current) to be applied to the LED blocks 64 can be controlled accurately, the accurate luminance control is enabled, and high-definition video expression is enabled.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. A flexible printed circuit has ICs which drive display devices, connection wirings which connect the ICs and wirings on a display panel, and a resistor which is formed by the same process as the connection wirings. The ICs have a compensation circuit which compensates a voltage drop on the connection wirings. The compensation circuit applies an electric current flowing in the connection wirings or an electric current corresponding to this electric current to the resistor, so as to obtain a signal for compensating the voltage drop on the connection wirings. As a result, the voltage drop of the connection wirings on the flexile printed circuit can be accurately compensated.

**Claims**

1. A drive circuit that drives a display panel having display devices and wirings to be connected to the display devices, comprising:

   a flexible printed circuit which has ICs which drive the display devices, connection wirings which connect the ICs and the wirings, and a first resistor which is formed by the same process as the connection wirings,

   wherein the ICs have a compensation circuit which compensates a voltage drop in the connection wirings, and the compensation circuits apply electric currents flowing in the connection wirings or electric currents corresponding to the electric currents to the first resistors so as to obtain signals for compensating the voltage drop in the connection wirings.

**2.** A drive circuit according to claim 1, wherein

the display panel has a plurality of display devices and a plurality of wirings to be connected to the plurality of display devices, respectively,

the ICs have a plurality of output terminals corresponding to the plurality of wirings,

the plurality of connection wirings one-to-one connect the plurality of output terminals and the plurality of wirings, and

the first resistor is arranged on an opposite side to the plurality of connection wirings across the ICs.

**3.** A drive circuit according to claim 1 or 2, wherein

the compensation circuit includes a feedback control circuit that maintains an output potential of the ICs at a target potential, and an operational circuit which obtains a signal for compensating a voltage drop on the connection wirings based on a potential difference between both ends of the first resistor at the time of applying the electric current flowing in the connection wirings or the electric current corresponding to this electric current to the first resistor, and the target potential is adjusted by the signal for compensating the voltage drop on the connection wirings.

**4.** A drive circuit according to any one of claims 1 to 3, wherein the first resistor has a resistance value which is the same as or proportional to a resistance value of the connection wirings.

**5.** A drive circuit according to any one of claims 1 to 4, further comprising:

a control circuit which outputs a signal to the ICs;

a circuit substrate which holds the control circuit; and

a second resistor which is connected to the first resistor in series,

wherein the second resistor is arranged on the circuit substrate.

**6.** A drive circuit according to claim 5, wherein the second resistor has a resistance value which is the same as or proportional to a resistance value of the wirings between the connection wirings and the display devices.

**7.** A drive circuit according to claim 3, further comprising:

a line which feeds back potentials at potential detecting points provided on the connection wirings to the feedback control circuit,

wherein the first resistor has a resistance value which is the same as or proportional to a resistance value of the connection wirings between the potential detecting points and the end portions of the connection wirings on the display panel side.

**8.** A drive circuit according to claim 7, wherein positions of the potential detecting points of the connection wirings are determined so that lengths from the potential detecting points to the end portions of the connection wirings on the display panel side are equal on all the connection wirings.

**9.** A display apparatus, comprising:

the drive circuit according to any one of clams 1 to 8; and

a display panel that is driven by the drive circuit.

*Fig. 1*

Fig. 2A

Fig. 2B

LINE SELECTION SIGNAL
SHIFT CLOCK SIGNAL
SHIFT DATA

SHIFT REGISTER

REF

SWITCH

*Fig. 3*

PRIOR ART

*Fig. 4*

100 SHIFT CLOCK

101 N-LINE NON-SELECTION SW

102 N-LINE SELECTION SW

103 N-LINE FB_SW

104 N+1-LINE NON-SELECTION SW

105 N+1-LINE SELECTION SW

106 N+1-LINE FB_SW

107 N-LINE DRIVE WAVEFORM (B)

108 N+1-LINE DRIVE WAVEFORM (B)

109 MODULATION SIGNAL WAVEFORM

*Fig. 5*

EP 2 096 621 A2

*Fig. 6*

*Fig. 7*

*Fig. 8*

Fig. 9

*Fig. 10*

*Fig. 11*

PRIOR ART

Fig. 12A

Fig. 12B

**EP 2 096 621 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004233620 A